# EUROPEAN PATENT SPECIFICATION

(11) **EP 2 280 237 B1**
(45) Date of publication and mention of the grant of the patent: **03.06.2015**
(21) Application number: 09009943.3
(22) Date of filing: 31.07.2009
(51) Int. Cl.: F28D 15/02, F28F 1/32, H01L 23/427

(54) **Heat sink having heat-dissipating fins of large area and method for manufacturing the same**
Kühlkörper mit wärmeableitenden Rippen für einen großen Bereich und Herstellungsverfahren dafür
Dissipateur de chaleur doté d'ailettes à dissipation de chaleur pour grande surface et son procédé de fabrication

(43) Date of publication of application: 02.02.2011
(73) Proprietor: CPUMATE INC., Taipei County 248 (TW); Golden Sun News Techniques Co., Ltd., Taipei County 248 (TW)
(72) Inventor: Lin, Kuo-Len, Taipei County 248 (TW); Lin, Chen-Hsiang, Taipei County 248 (TW); Hsu, Ken, Taipei County 248 (TW); Cheng, Chih-Hung, Taipei County 248 (TW)
(74) Representative: Ter Meer Steinmeister & Partner

(56) References cited:
- EP-A- 0 791 794
- FR-A- 1 602 080
- US-A- 3 149 667
- US-A- 4 592 420
- US-A1- 2008 257 527

## Description

### BACKGROUND OF THE INVENTION

### 1. Field of the Invention

The present invention relates to a heat sink according to the preamble of claim 1, and in particular to a heat-dissipating fin of a large area capable of increasing the total heat-dissipating area in a stack of heat-dissipating fins, a heat sink having such heat-dissipating fins.

### 2. Description of Prior Art

With the rapid advancement of the computer industry, the operating speed of electronic elements increases to a much larger extent, and thus the amount of heat generated by the electronic elements is increased accordingly. Therefore, in order to maintain the electronic elements to operate continuously at an admissible range of temperature. It is well known to use a heat sink to dissipate the heat generated by the electronic elements. The current heat sink is usually provided with a heat pipe, in which a heat-conducting substance is used to help the heat sink to dissipate the heat by means of the phase change between the liquid state and the vapor state of the heat-conducting substance. In addition, heat-dissipating fins penetrate a condensing end of the heat pipe also has have an influence on the total heat-dissipating efficiency.

In an aluminum-extruded heat sink, owing to the limitation in the conventional manufacturing process, the heat-dissipating fins must have a certain thickness and pitch, and these heat-dissipating fins are stacked up to form a heat sink. Since the heat-dissipating fin is thinner and the pitch between the respective heat-dissipating fins is small, the whole heat-dissipating area of the heat sink can be increased substantially, and thus the heat-dissipating efficiency can be improved. However, in order to further increase the area of the fins in the heat sink, manufacturers in this field attempt to increase the dimension of each heat-dissipating fin to thereby increase the total heat-dissipating area. Further, the heat-dissipating fin can be made waved to increase the heat-dissipating area. Although the above-mentioned solutions can increase the heat-dissipating area of the heat sink, the increase is so limited and the volume of the whole heat sink may be adversely increased.

Therefore, in order to solve the above-mentioned problems, the present Inventor proposes a reasonable and novel structure based on his deliberate research and expert experiences.

EP 0 791 794 A1 describes a condenser for air-conditioning systems for vehicles. Herein, a condenser for air-conditioning systems for vehicles comprises at least one row of tubes fixed to a pack of substantially flat fins by the mechanical expansion of the tubes after they have been inserted in aligned holes in the fins. At least a substantial number of the fins have side portions which are thicker than the remaining portions of the fins. The thicker portion is preferably produced by the bending of an end portion of the fin onto itself. After the bending, the holes for the passage of the tubes, and the respective collars, are formed in the fins. The holes for housing the end tubes are formed entirely in the thicker portion. The fins of EP 0791 794 A1 correspond to the preamble of claim 1.

US 3,149,667 A describes a core-unit for vehicular-radiator-type heat exchanger and protective shields therefore. A core-unit comprises a battery of tubes mounting a series of fins with the leading edges of the front row of tubes embraced in protective shields. The tubes in such a radiator are of a flat, elongated form and arranged in staggered relationship, as shown in figure. The ends of the tubes extend a sufficient distance beyond the upper and lower fins to permit telescopic positioning of the tube ends in registering openings in and bonding to header plates for the upper and lower tanks of the radiator. The fins are formed with apertures to snugly embrace the tubes and are arranged in closely-spaced relationship to each other. Generally, the fins are formed with flanges around the tube apertures to contactively embrace the tubes and thereby enhance the heat-transfer facility of the tubes to the fins.

US 4,592,420 A describes a reinforced plate fin heat exchanger. A plurality of thin plate fins made of thermally conductive material are disposed in generally parallel relation to form a stack, wherein the plate fins are stacked on tubes, which extend through open tube holes of the fins. Opposite edges and of each plate fin are provided with reversed folds for strengthening purposes in these areas. Further, each plate fin is provided with a series of generally H-shaped deformations formed of two spaced first ridges and and a second ridge.

FR 1.602.080 describes a heat-dissipating fin of a radiator. A heat-dissipating fin is formed by bending a plate at an edge portion thereof to form clips and. The heat-dissipating fin is further perforated to have passages, through which tubes extend, to stack a plurality to heat-dissipating fins.

US 2008/0257527 A1 describes a heat sink assembly having a fin also functioning as a supporting bracket. A heat sink assembly for cooling a heat-generating electronic component includes a base plate, a plurality of fins mounted on the base plate and a heat pipe thermally connecting the base plate and the fins. The fins are parallel to the base plate and include a bottom fin supporting the fins on the base plate. The bottom fin includes a plurality of supporting tabs engaging with the base plate and separating a body of the bottom fin from the base plate. The bottom fin can be used not only for dissipating heat into a surrounding environment but also for reinforcing the whole strength of the heat sink assembly. The heat pipe comprises a horizontal evaporating portion and a vertical condensing portion arranged in such a manner that the heat pipe has an L-shaped configuration.

### SUMMARY OF THE INVENTION

It is an object of the present invention to provide a heat-dissipating fin having a larger surface area to contact with air for better heat-dissipation, and a heat sink comprising the same.

This object is solved by the heat-dissipating fin according to claim 1 and by a heat sink according to claim 3. Further advantages, refinements and embodiments of the invention are described in the respective sub-claims.

The present invention is to provide a heat-dissipating fin of a large area, and a heat sink having such heat-dissipating fins. Without increasing the volume of the heat-dissipating fin significantly, the area of the heat-dissipating fins can be increased substantially by means of bending and overlapping the heat-dissipating fins. Then, the plurality of heat-dissipating fins can be used to form a heat sink. Thus, the heat-dissipating efficiency of the heat-dissipating fins or the heat sink can be increased.

The present invention is to provide a heat-dissipating fin of a large area according to claim 1.

### BRIEF DESCRIPTION OF THE DRAWINGS

FIG. 1 is a flow chart showing the process for manufacturing the heat-dissipating fin according to the present invention;
FIG. 2 is a view showing the external appearance of the heat-dissipating fin according to a first embodiment of the present invention;
FIG. 3 is an exploded view of the heat-dissipating fin according to the first embodiment of the present invention;
FIG. 4 is a view showing the action for bending the heat-dissipating fin according to the first embodiment of the present invention;
FIG. 5 is a view showing the action for punching the heat-dissipating fin according to the first embodiment of the present invention;
FIG. 6 is a partially cross-sectional view showing the heat-dissipating fins according to the second embodiment of the present invention;
FIG. 7 is a flow chart showing the process for manufacturing the heat sink of the present invention;
FIG. 8 is an exploded perspective view showing the heat sink according to the first embodiment of the present embodiment;
FIG. 9 is an assembled perspective view showing the heat sink according to the first embodiment of the present embodiment;
FIG. 10 is a cross-sectional view showing the heat sink according to the first embodiment of the present embodiment;
FIG. 11 is a cross-sectional view showing the heat sink according to the second embodiment of the present embodiment; and
FIG. 12 is a cross-sectional view showing the heat sink according to the third embodiment of the present embodiment.

### DETAILED DESCRIPTION OF THE INVENTION

For further understanding of the characteristics and technical contents of the present invention, a detailed description will be made with reference to the accompanying drawings. However, the drawings are illustrative only but not used to limit the present invention.

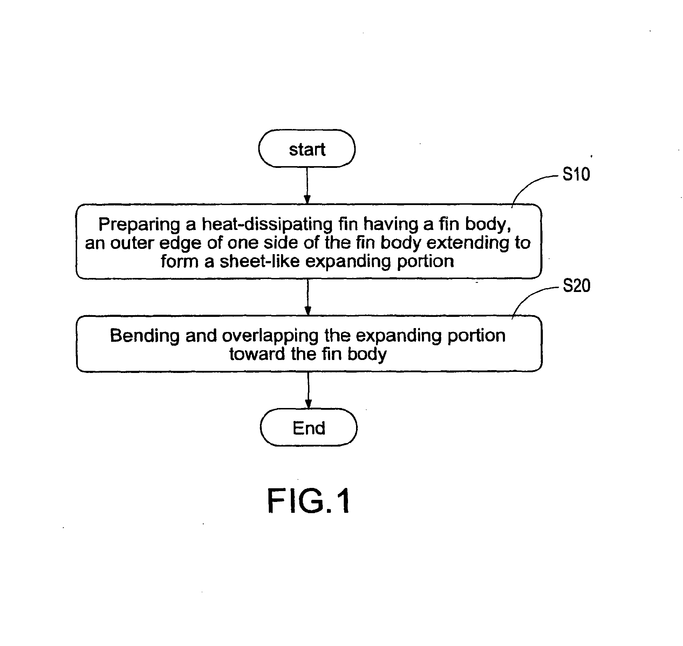

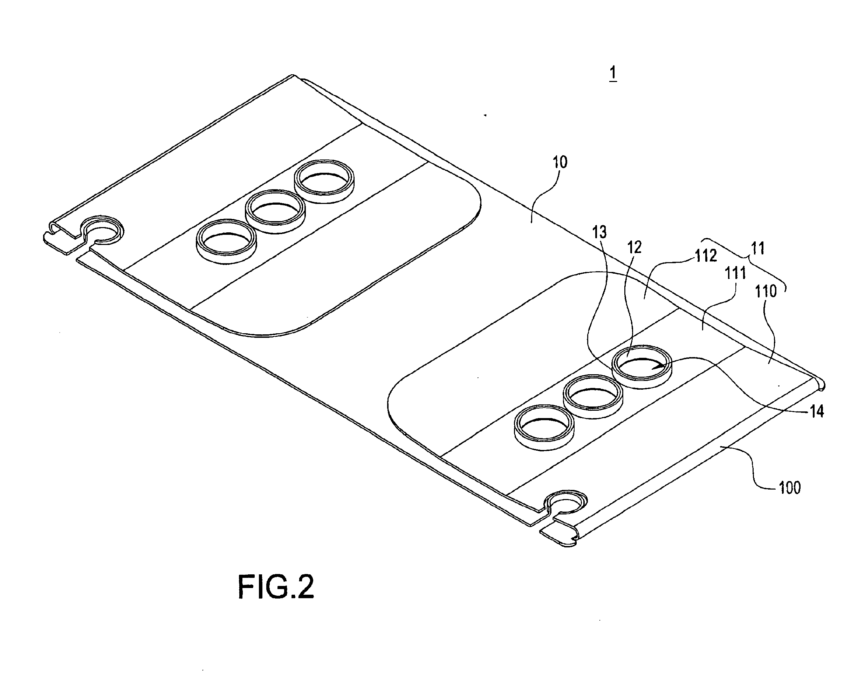

The present invention provides a heat-dissipating fin of a large area. Please refer to FIGS. 1 and 2. FIG. 1 is a flow chart showing the process for manufacturing the heat-dissipating fin according to the present invention, and FIG. 2 is a view showing the external appearance of the heat-dissipating fin according to a first embodiment of the present invention. The heat-dissipating fin 1 has a fin body 10 made of metallic materials of good heat-dissipating property. An outer edge of one side of the fin body 10 extends to form a sheet-like expanding portion 11. The expanding portion 11 is used to increase the heat-dissipating area of the heat-dissipating fin 1. The expanding portion 11 is bent and overlapped on the fin body 10. Thus, in this way, without increasing the volume of the heat-dissipating fin 1, the total heat-dissipating area can be increased.

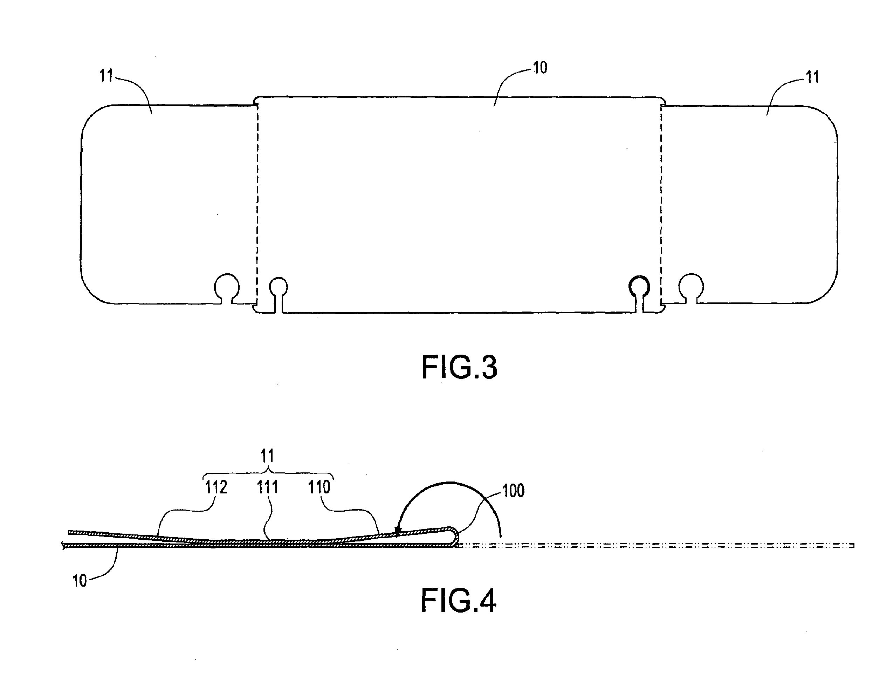

Please refer to FIGS. 1 and 3. In a step S10, first, a metallic sheet of good heat-dissipating property is prepared, by means of which the heat-dissipating 1 can be made. The metallic sheet is made flat and expanded (as shown in FIG. 3) by means of a press-forming process, thereby forming the fin body 10. At least an outer edge of one side of the fin body 10 extends to form a sheet-like expanding portion 11.

Please refer to FIGS. 1 and 4. In a step S20, the expanding portion 11 is bent toward the fin body 10, so that the expanding portion 11 is overlapped on the fin body 10. In this step, a curved section 100 bent reversely is integrally formed between the fin body 10 and the expanding portion 11, so that a gap is formed between the fin body 10 and the expanding portion 11 and thus the total area of both surfaces of the expanding portion 11 can be used for heat dissipation. In the present embodiment, the expanding portion 11 comprises a first extending section 110, a perforated section 111 and a second extending section 112. The first extending section 110 extends from the outer edge of one side of the fin body 10. A curved section 100 is integrally connected to the fin body 10. A gap is formed between the first extending section 110 of the expanding portion 11 and the fin body 10.

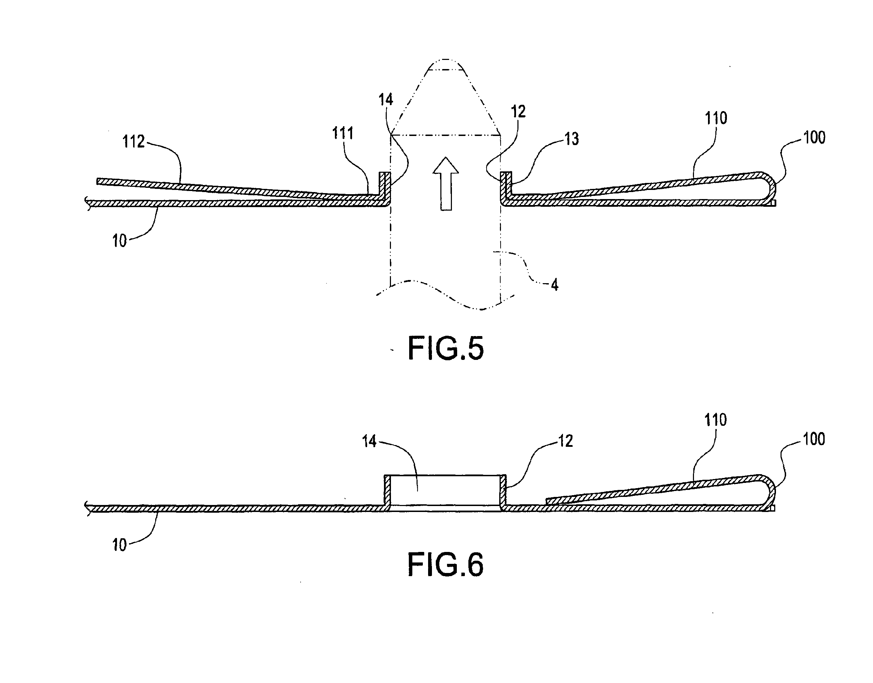

The perforated section 111 of the expanding portion 11 is formed by extending from the distal edge of the first extending section 110, so that it can be perforated. As shown in FIG. 5, by means of a perforating punch 4, through-holes 14 can be made on the fin body 10 corresponding to the perforated section 111. In the present embodiment, the perforating punch 4 penetrates into the fin body 4 to form respectively an outer annular wall 13 on the perforated section 111 and an inner annular wall 12 on the fm body 10 to be located inside the outer annular wall 13. Inside the inner annular wall 12 and the outer annular wall 13, a through-hole 14 is formed for allowing a heat-conducting element (later described) to penetrate therein. On the contrary, the perforating punch 4 can penetrates into the perforated section 111, so that the inner annular wall 12 can be formed on the perforated section 111 and the outer annular wall 13 can be formed on the fin body 10. In this way, a through-hole 14 identical to the previous one can be also formed.

The second extending section 112 of the expanding portion 11 is formed by extending from the distal edge of the perforated section 111, thereby increasing the heat-dissipating area of the heat-dissipating fin 1. The second extending section 112 is inclined upwards from the fin body 10 without contacting the fin body 10. With this arrangement, the second extending section 112 can have a larger surface area to contact with air for better heat dissipation.

In the present embodiment, the outer edges of both sides of the fin body 10 can be extended to form an expanding portion 11 respectively. The extended length of the expanding portion 11 can be smaller than half of the fin body 10. Alternatively, in the previous case that only one side of the fin body 10 is provided with the expanding portion 11, the extended length of the expanding portion 11 is smaller than that of the fin body 10.

Further, please refer to FIG. 6, which is a partially cross-sectional view showing the second embodiment of the heat-dissipating fins of the present invention. Under the circumstance that the expanding portion 11 of the heat-dissipating fin 1 has only one first extending section 110, the fin body 10 is provided with the inner annular wall 12 and the through-hole 14. The present embodiment also allows a heat-conducting element (later described) to penetrate therein.

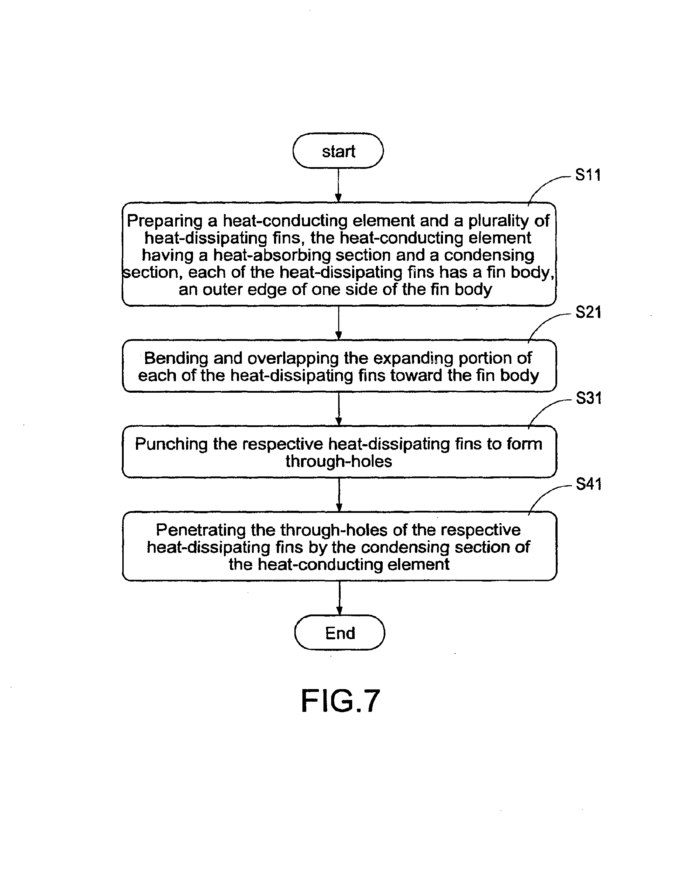

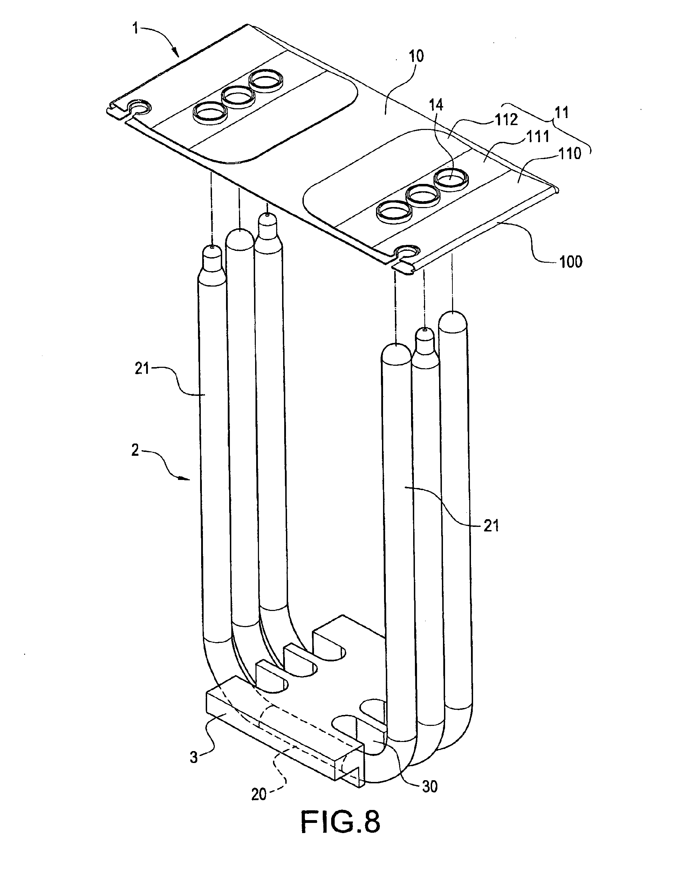

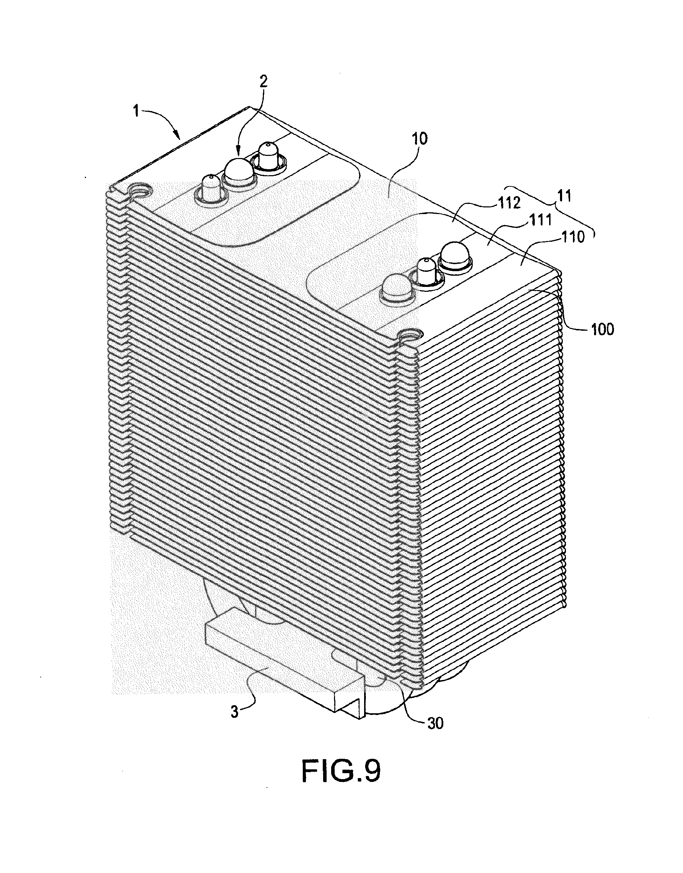

In addition, the present invention also provides a heat sink having such heat-dissipating fins and a method for manufacturing the same. Please refer to FIGS. 7 to 9. FIG. 7 is a flow chart showing the process for manufacturing the heat sink of the present invention. FIG. 8 and FIG. 9 are an exploded perspective view and an assembled perspective view showing the heat sink according to the first embodiment of the present embodiment respectively. The heat sink includes a plurality of heat-dissipating fins 1 and at least one heat-conducting element 2. The heat-conducting element 2 penetrates the through-holes 14 of the respective heat-dissipating fins 1, thereby forming a heat sink having the heat-dissipating fins. Without increasing the volume occupied by the respective heat-dissipating fins significantly, the total heat-dissipating area can be increased.

Please refer to FIGS. 7 and 4. In a step S11, first, at least one heat-conducting element 2 and the plurality of heat-dissipating fins 1 are prepared. Since the heat-dissipating fins 1 have been described in the above paragraphs, the description thereof is omitted for clarity. The heat-conducting element 2 may be a heat pipe or a vapor chamber, which is formed to have a heat-absorbing section 20 and at least one condensing section 21. In the present embodiment, the heat-conducting element 2 is a heat pipe, which is formed into U shape. The bottom section of the U-shaped heat pipe is configured as the heat-absorbing section 21, while both ends of the U-shaped heat pipe are configured as the condensing sections 21 respectively.

Please refer to FIGS. 7 and 4. In a step S21, the expanding portion 11 of each heat-dissipating fin 1 is bent toward the fin body 10, so that the expanding portion 11 of each heat-dissipating fin 1 can be overlapped on the fin body 10. Since this step is the same as that in the process for manufacturing the heat-dissipating fins 1, the only difference is to make a plurality of heat-dissipating fins in this step. Thus, the description relating thereto is omitted for clarity.

Please refer to FIGS. 7 and 5. In a step S31, the thus-formed heat-dissipating fins 1 are punched to form through-holes 14 respectively. The through-holes 14 on the respective heat-dissipating fins 1 correspond to each other. The description of this step is the same as that in the above.

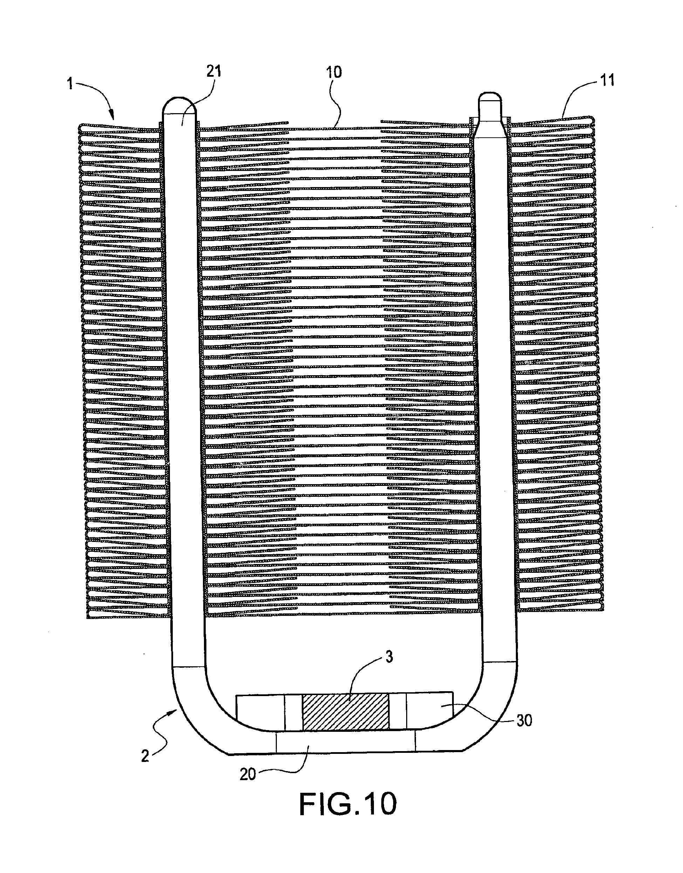

Please refer to FIGS. 7 and 8. In a step S41, the condensing section 21 of the heat-conducting element 2 penetrates the through-holes 14 of the respective heat-dissipating fins 1, thereby forming a heat sink (as shown in FIG. 9) having a stack of heat-dissipating fins. Please refer to FIGS. 8 to 10, in order to bring the heat-absorbing section 20 of the heat-conducting element 2 into surface contact with a heat-generating source (not shown) more easily, the heat sink further comprises a base 3. The base 3 is provided on the heat-absorbing section 20 of the heat-conducting element 2 to be thermally connected thereto. The bottom surface of the base 3 is provided with a groove 30 for allowing the heat-absorbing section 20 of the heat-conducting element 2 to be embedded therein. The heat-absorbing section 20 of the heat-conducting element 2 can be also emerged from the bottom surface of the base 3, thereby contacting a heat-generating source (not shown) directly.

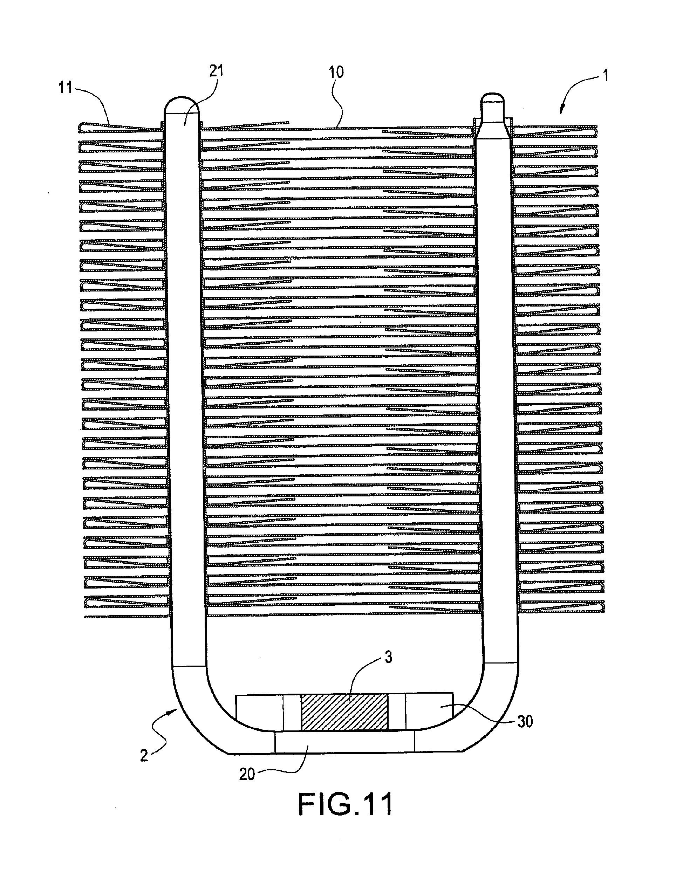

Please refer to FIG. 11, which is a cross-sectional view showing the heat sink according to the second embodiment of the present invention. If only one side of each of the heat-dissipating fins 1 is provided with the expanding portion 11, the heat-dissipating fins 1 can be arranged in a staggered manner, thereby facilitating to overlap these heat-dissipating fins 1.

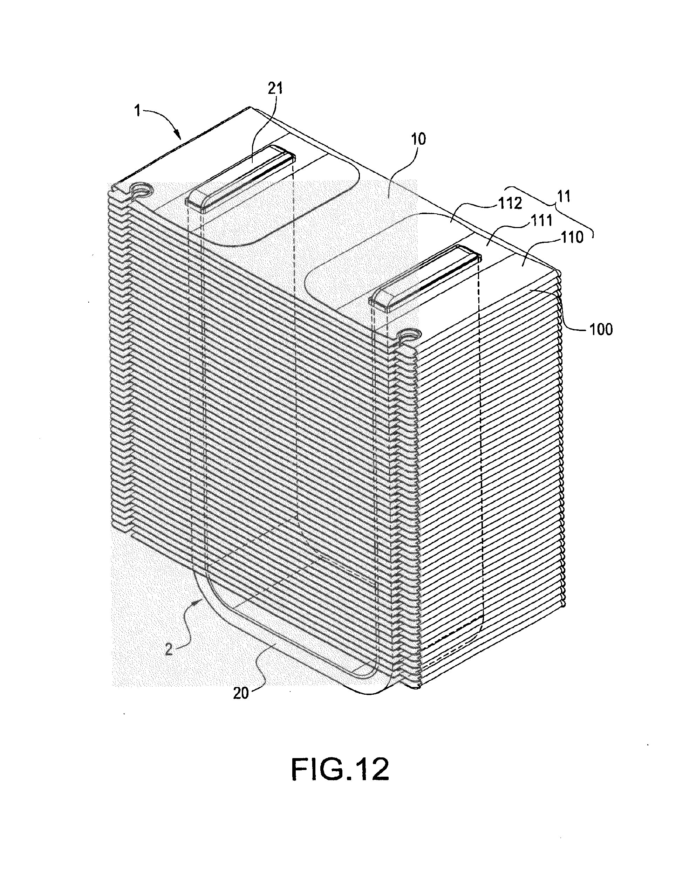

Please refer to FIG. 12, which is a cross-sectional view showing the heat sink according to the third embodiment of the present invention. The heat-conducting element 2 is a vapor chamber that cooperates with the through-holes 14. The other structural characteristics are the same as those in the previous embodiments.

## Claims

1. A heat-dissipating fin of a large area having a fin body (10), an outer edge of one side of the fin body (10) extending to form a sheet-like expanding portion (11), the expanding portion (11) being bent and partially overlapped on the fin body (10), wherein the expanding portion (11) has a first extending section (110), a curved section (100) is integrally connected between the fin body (10) and the first extending section (110), the expanding portion (11) further extends from a distal edge of the first extending section (110) to form a perforated section (111), the perforated section (111) is adhered to the fin body (110) the fin being **characterised in that** a gap is formed between the fin body (10) and the expanding portion (11), and **in that** the expanding portion (11) further extends from a distal edge of the perforated section (111) to form a second extending section (112), the second extending section (112) is inclined upwards from the fin body (10).

2. The heat-dissipating fin of a large area according to claim 1, wherein an outer edge of the other side of the fin body (10) also extends to form a sheet-like expanding portion (11), the other expanding portion (11) is also bent and overlapped on the fin body (10).

3. A heat sink, comprising:
- a plurality of heat-dissipating fins (1) according to claims 1 or 2; and
- a heat-conducting element (2) having a heat-absorbing section (20) and a condensing section (21);
wherein each of the heat-dissipating fins (1) is provided with corresponding through-holes (14), the condensing section (21) of the heat-conducting element (2) penetrates the through-hole (14) of each heat-dissipating fin (1) to thereby overlap the heat-dissipating fins (1) on the condensing section (21) of the heat-conducting element (2).

4. The heat sink according to claim 3, wherein the through-hole (14) is located on the fin body (10) corresponding to the perforated section (111).

5. The heat sink according to claim 4, wherein the perforated section (111) is provided with an outer annular wall (13), the fin body (10) is provided with an inner annular wall (12) located inside the outer annular wall (13), the through-hole (14) is formed in the inner annular wall (12) and the outer annular wall (13).

6. The heat sink according to claim 3, wherein the heat-dissipating fins (6) are arranged in a staggered manner.

7. The heat sink according to claim 2 and 3, wherein a length formed by extending from the two expanding portions (11) is smaller than half of the fin body (10).

8. The heat sink according to claim 3, further comprising a base (3), the base (3) being provided on the heat-absorbing section (20) of the heat-conducting element (2).

## Patentansprüche

1. Wärmeableitende Finne mit einer großen Fläche mit einem Finnenkörper (10), wobei sich eine äußere Kante einer Seite des Finnenkörpers (10) erstreckt, um einen blattförmigen Erweiterungsabschnitt (11) zu bilden, wobei der Erweiterungsabschnitt (11) gebogen ist und teilweise von dem Finnenkörper (10) überdeckt wird, wobei der Erweiterungsabschnitt (11) einen ersten Verlängerungsabschnitt (110) besitzt, wobei ein gebogener Abschnitt (100) einteilig zwischen dem Finnenkörper (10) und dem ersten Verlängerungsabschnitt (110) verbunden ist, wobei die Finne **dadurch gekennzeichnet ist, dass** sich der Erweiterungsabschnitt (11) ferner von einer distalen Kante des ersten Verlängerungsabschnitts (110) erstreckt, um einen durchlöcherten Abschnitt (111) zu bilden, wobei der durchlöcherte Abschnitt (111) an den Finnenkörper gebunden ist, wobei eine Lücke zwischen dem Finnenkörper (10) und dem Erweiterungsabschnitt (11) gebildet ist, und dadurch, dass sich der Erweiterungsabschnitt (11) ferner von einer distalen Kante des durchlöcherten Abschnitts (111) erstreckt, um einen zweiten Verlängerungsabschnitt (112) zu bilden, wobei der zweite Verlängerungsabschnitt (112) von dem Finnenkörper (10) nach oben geneigt ist.

2. Wärmeableitende Finne mit einer großen Fläche nach Anspruch 1, wobei sich eine äußere Kante der anderen Seite des Finnenkörpers (10) auch erstreckt, um einen blattförmigen Erweiterungsabschnitt (11) zu bilden, wobei der andere Erweiterungsabschnitt (11) auch gebogen ist und auf dem Finnenkörper (10) überdeckt ist.

3. Wärmesenke, die umfasst:
- mehrere wärmeableitende Finnen (1) nach den Ansprüchen 1 oder 2; und
- ein wärmeleitendes Element (2) mit einem wärmeabsorbierenden Abschnitt (20) und einem Kondensationsabschnitt (21);
wobei jede der wärmeableitenden Finnen (1) mit entsprechenden Durchgangslöchern (14) versehen ist, wobei der Kondensationsabschnitt (21) des wärmeleitenden Elements (2) in das Durchgangsloch (14) einer jeden wärmeableitenden Finne (1) eindringt, um dadurch die wärmeableitenden Finnen (1) auf dem Kondensationsabschnitt (21) des wärmeleitenden Elements (2) zu überdecken.

4. Wärmesenke nach Anspruch 3, wobei sich das Durchgangsloch (14) entsprechend dem durchlöcherten Abschnitt (111) auf dem Finnenkörper (10) befindet.

5. Wärmesenke nach Anspruch 4, wobei der durchlöcherte Abschnitt (111) mit einer äußeren ringförmigen Wand (13) versehen ist, wobei der Finnenkörper (10) mit einer inneren ringförmigen Wand (12), die sich innerhalb der äußeren ringförmigen Wand (13) befindet, versehen ist, wobei das Durchgangsloch (14) in der inneren ringförmigen Wand (12) und der äußeren ringförmigen Wand (13) gebildet ist.

6. Wärmesenke nach Anspruch 3, wobei die wärmeableitenden Finnen (6) in einer versetzten Weise angeordnet sind.

7. Wärmesenke nach Anspruch 2 und 3, wobei eine Länge, die durch Verlängerung von den beiden Erweiterungsabschnitten (11) gebildet ist, kleiner als die Hälfte des Finnenkörpers (10) ist.

8. Wärmesenke nach Anspruch 3, die ferner eine Basis (3) umfasst, wobei die Basis (3) auf dem wärmeabsorbierenden Abschnitt (20) des wärmeleitenden Elements (2) vorgesehen ist.

## Revendications

1. Ailette de dissipation de chaleur à grande surface ayant un corps d'ailette (10), une bordure extérieure d'un côté du corps d'ailette (10) s'étendant pour former une portion en expansion semblable à une feuille (11), la portion en expansion (11) étant cintrée et partiellement en recouvrement sur le corps d'ailette (10), dans laquelle la portion en expansion (11) comprend une première section en extension (110), une section incurvée (100) qui est connectée intégralement entre le corps d'ailette (10) et la première section en extension (110), la portion en expansion (11) s'étend en outre depuis un bord distal de la première section en extension (110) pour former une section perforée (110), la section perforée (111) étant adhérée sur le corps d'ailette (110),
l'ailette étant **caractérisée en ce qu'**un intervalle est formé entre le corps d'ailette (10) et la portion en expansion (11), et **en ce que** la portion en expansion (11) s'étend en outre depuis un bord distal de la section perforée (111) pour former une seconde section en extension (112), la seconde section en extension (112) étant inclinée vers le haut depuis le corps d'ailette (10).

2. Ailette de dissipation de chaleur à grande surface selon la revendication 1, dans laquelle un bord extérieur de l'autre côté du corps d'ailette (10) s'étend également pour former une portion en expansion semblable à une feuille (11), ladite autre portion en expansion (11) étant également cintrée et en recouvrement sur le corps d'ailette (10).

3. Puits de chaleur, comprenant :
- une pluralité d'ailettes de dissipation de chaleur (1) selon les revendications 1 ou 2 ; et
- un élément conducteur de chaleur (2) ayant une section d'absorption de chaleur (20) et une section de condenseur (21) ;
dans lequel chacune des ailettes de dissipation de chaleur (1) est pourvue de trous traversants correspondants (14), la section de condenseur (21) de l'élément conducteur de chaleur (2) pénètre dans le trou traversant (14) de chaque ailette de dissipation de chaleur (1) pour chevaucher ainsi les ailettes de dissipation de chaleur (1) sur la section de condenseur (21) de l'élément conducteur de chaleur (2).

4. Puits de chaleur selon la revendication 3, dans lequel le trou traversant (14) est situé sur le corps d'ailette (10) correspondant à la section perforée (111).

5. Puits de chaleur selon la revendication 4, dans lequel la section perforée (111) est dotée d'une paroi annulaire extérieure (13), le corps d'ailette (10) est doté d'une paroi annulaire intérieure (12) située à l'intérieur de la paroi annulaire extérieure (13), le trou traversant (14) étant formé dans la paroi annulaire intérieure (12) et dans la paroi annulaire extérieure (13).

6. Puits de chaleur selon la revendication 3, dans lequel les ailettes de dissipation de chaleur (6) sont agencées d'une manière étagée.

7. Puits de chaleur selon la revendication 2 et 3, dans lequel une longueur formée par une extension depuis les deux portions en expansion (11) est plus petite que la moitié du corps d'ailette (10).

8. Puits de chaleur selon la revendication 3, comprenant en outre une base (3), la base (3) étant prévue sur la section d'absorption de chaleur (20) de l'élément conducteur de chaleur (2).
